# EUROPEAN PATENT APPLICATION

(11) **EP 0 533 608 A2**
(43) Date of publication of application: **24.03.1993**
(21) Application number: 92480121.0
(22) Date of filing: 28.08.1992
(51) Int. Cl.: G06F 11/00, G06F 11/20

(54) **Method and apparatus for ensuring the recoverability of vital data in a data processing system**

(30) Priority: 18.09.1991 US 762536
(71) Applicant: International Business Machines Corporation, Armonk, N.Y. 10504 (US)
(72) Inventor: Douskey, Steven M., Rochester, MN 55901 (US)
(74) Representative: de Pena, Alain

(57) **Abstract**

A method and apparatus for ensuring the recoverability of vital data in a data processing system. Vital data (30), such as manufacturer code, serial number or configuration data, is stored as a plurality of binary bits at a first address (32-000) within a memory associated with the data processing system. The vital data is then stored at a second address (32-111) within memory in a logically inverted form such that data line errors present in memory interface may be overcome by reading the vital data from the second address. In one embodiment of the present invention vital data is stored at a second address which is a logical inverse of the first address. In this manner address line errors may be overcome by reading the vital data from the second address.

## Description

The present invention relates in general to the field of methods and systems for data storage and retrieval within data processing systems and in particular to methods and systems for ensuring the recoverability of a vital data within a data processing system despite the existence of data or address line faults. Still more particularly the present invention relates to a method and system for storing vital data within a data processing system at multiple addresses and in multiple formats such that vital data may be recoverable despite internal memory device faults or interface errors associated with the memory device.

The storage of data within data processing systems is well known in the prior art. However, in view of the fact that memory devices are not totally reliable it is not uncommon for data to be distorted or lost. Therefore, it is a common practice in the computer arts to retain a so-called "back-up" copy of selected data, within a transportable magnetic storage media such as magnetic disk or magnetic tape. While this practice permits a user to ensure the recoverability of certain data it is not generally adapted to systems which do not utilize disk or tape storage. As a consequence, many different systems and methods have been proposed to ensure the recoverability of vital data from memory devices within a data processing system.

For example, the United States Patent Number 4,458,349 describes a method of operating a fault-tolerant semiconductor memory which increases the probability that data words read from memory will not contain uncorrectable errors. This method involves the testing of each data word transferred to memory to determine if the true form or compliment form will result in an error on readout. If the true form results in an error indication the data portion of the word is stored in compliment form and the check byte is stored in true form. On a subsequent transfer of the word from memory the error correction system indicates an apparent uncorrectable error resulting from both portions of the word being stored in a different form, while in fact the uncorrectable error indications are a signal that the data portion was stored in compliment form. This arrangement permits the error correction system to correct soft or intermittent type errors, even though they may occur at a memory address having a defect. This method is relatively complex in that it requires both an error correction system which must perform error checking when the data is stored and again when the data is retrieved. Further, the system requires the error correction system to append a check byte to each data word.

United States Patent Number 4,592,024 describes another method for error corre ction wherein the address of each defective memory cell within a semiconductor memory is stored in advance in memory. This method requires prior knowledge of the locations of all memory defects and also requires additional circuitry to produce a correcting signal which inverts erroneous data bits. As with the system described above, the method of United States Patent Number 4,592,024 is not tolerant of faults which occur on the address lines or data lines connected to the memory device.

United States Patent Number 4,712,216 describes an error correction method and device which utilizes Hamming codes and an error correction system. This system utilizes bit configurations which are arranged in M-bit code words, each word comprising a number D of data bits and an even number N of error correcting bits.

United States Patent Number 4, 615,030 describes a novel semiconductor memory chip which includes a self-diagnosis circuit which corrects internal errors through row and column error detection schemes. While this technique may be utilized to detect data which is erroneous as a result of internal memory chip errors such a scheme cannot be utilized to compensate for address or data line errors.

Finally, United States Patent Number 4,748,594 describes a integrated circuit device having a relatively fault tolerant memory, however, this system utilizes a memory design-saving cell count which requires at least three copies of the data to correct errors utilizing a so-called "voting" scheme.

Each of the aforementioned systems is directed toward a technique for enhancing the recoverability of a data stored within a data processing system. It is also common in such systems to store data at one location within such a memory device with an associated error checking data packet such that if the systems reads invalid data from one location within the memory device the system will then attempt to read the data stored at an alternate location in a second attempt to obtain valid data.

While each of these systems and techniques is directed to the increasing of fault tolerance within the memory device by storing a second version of data there in none of the aforementioned systems is capable of recovering from faults which are present within the interface between the data processing system and the memory device. That is, faults which occur as a result of a stuck data or address line.

It should therefore be apparent that a need exists for simple method of data storage and retrieval which is tolerant of not only internal memory device faults but also of faults present within data or address interface to the memory device.

It is therefore one object of the present invention to provide an improved method of data storage and retrieval within a data processing system.

It is another object of the present invention to provide a method and apparatus for ensuring the recoverability of vital data within a data processing system despite the existence of faults within the system.

It is yet another object of the present invention to provide a method and apparatus for storing vital data in a memory device at multiple addresses in different formats such that the vital data will be recoverable despite faults internal to the memory device or faults within an interface to the memory device.

The foregoing objects are achieved as is now described. The method and apparatus of the present invention may be utilized to ensure the recoverability of vital data within a data processing system. Vital data, such as manufacturer code, serial number or configuration data, is stored as a plurality of binary bits at a first address within a memory associated with the data processing system. The vital data is then stored at a second address within memory in a logically inverted form such that data line errors present in memory interface may be overcome by reading the vital data from the second address. In one embodiment of the present invention vital data is stored at a second address which is the logical inverse of the first address. In this matter address line errors may be overcome by reading the vital data from the second address.

The above as well as additional objects, features, and advantages of the invention will become apparent in the following detailed description.

The novel features believed characteristic of the invention are set forth in the appended claims. The invention itself however, as well as a preferred mode of use, further objects and advantages thereof, will best be understood by reference to the following detailed description of an illustrative embodiment when read in conjunction with the accompanying drawings, wherein:
Figure 1 depicts a data processing system which may be utilized to implement the method and system of the present invention;
Figure 2 depicts an arrangement of data stored at selected addresses within a small memory device in accordance with the method and system of the present invention;
Figure 3 depicts a high level logic flow chart illustrating the storing of data within data processing system in accordance with a method and system of the present invention; and
Figure 4 depicts a high level logic flow chart illustrating the retrieval of data within a data processing system in accordance with a method and system of the present invention.

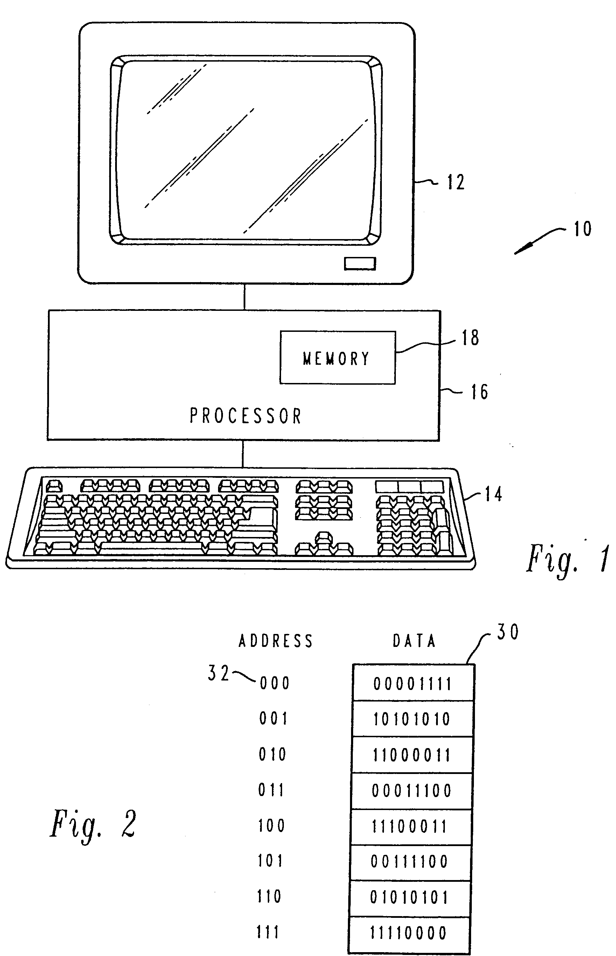

With reference now to the figures and in particular with reference to Figure 1, there is depicted a depicted a data processing system 10 which may be utilized to implement the method and system of the present invention. As is illustrated , data processing system 10 includes a processor 16 which is coupled to a keyboard 14 and monitor 12 in a manner well known to those in the computing art. For purposes of illustration data processing system 10 may be implemented utilizing a so-called "personal" computer such as the International Business Machines Corporation PS/2 computer or, alternately, a mid-range or main frame computer may be utilized, such as the International Business Machines System AS/400 computer.

Depicted within a processor 16 of data processing system 10 is a memory device 18. Those skilled in the computer art will appreciate that memory device 18 may be implemented utilizing any device capable of storing data including, but not limited to read only memory, random access memory, magnetic disk storage, magnetic tape storage or any combination thereof. As is common in such data processing systems certain data, including vital data, must be stored in association with data processing system 10. Vital data such as model number, serial number, software version number, manufacturer codes, configuration levels, dates or other identification data is typically stored within a data processing system 10 to be accessed by maintenance personnel or other individuals requiring access to such vital data.

As those skilled in the art will appreciate it is important that such vital data be stored accurately and be recoverable so that maintenance of data processing system 10 may be easily accomplished and may be accurately documented. Thus, in accordance with an important feature of the present invention each unit of vital data is stored twice by processor 16 within memory device 18. As will be explained in greater detail herein, the manner in which the second copy of the vital data is stored within memory device 18 must be accomplished in accordance with the method and system of the present invention in order to ensure the recoverability of that data.

With reference now to Figure 2 there is depicted an arrangement of data which is stored at selected addresses within a small memory device in accordance with the method and system of the present invention. As is illustrated, each unit of data as depicted within column 30 is stored at an address associated therewith which is listed within column 32. Thus, at address "000" the data word stored is "00001111". Similarly, at address "001" data word "10101010" is stored. Those skilled in the art will appreciate that this example is necessarily much simpler than an actual addressing scheme; however, the method and system of the present invention may be appreciated upon reference thereto.

In accordance with a first embodiment of the present invention each data word stored within column 30 is stored twice therein. Specifically, each data word is stored first within column 30 as a plurality of binary bits such as "00001111" at the top of column 30. Thereafter, this data word is stored in logically inverted form, that is, "11110000" at the bottom of column 30. As a cursory examination of the data within column 30 within Figure 2 will reveal, each data word stored within the top four rows of column 30 is stored a second time in a logically inverted format within the bottom four rows of column 30. In this manner, a stuck data line which reads permanently high or low may result in an error when reading data from the first four rows of column 30; however, a second read of the same data stored in logically inverted form from the second four rows of column 30 will result in a successful reading of the vital data. Thus, a stuck data line will not affect the recoverability of the vital data.

Still referring to Figure 2, a second important feature of the present invention may also be illustrated. That is, each data word stored in logically inverted form within column 30 is also stored in a logically inverted form at an address which is the logical inverse of the address of the original data. That is, data "00001111" stored at address "000" is stored at the logically inverted address "111" as data "11110000". Thus, as those skilled in the art will appreciate, an error in an address line utilized to access data within memory device 18 (see Figure 1) will not prevent the recoverability of vital data from memory device 18, since errors created by the stuck address line may be overcome by reading the data from the second address location, since each address location utilized for storage of the second group of data is an address which is the logical inverse of the addresses utilized with the first data group.

Upon reference to the forgoing those skilled in the art will appreciate that the method and system of the present invention can ensure the recoverability of vital data from storage within a data processing system without requiring complex hardware or software manipulation scenarios. By merely storing vital data in true form and logically inverted form at an address which is the logical inverse of the true form address, errors which occur as a result of a fault in the interface to the memory device may be overcome by reading the data from the second location.

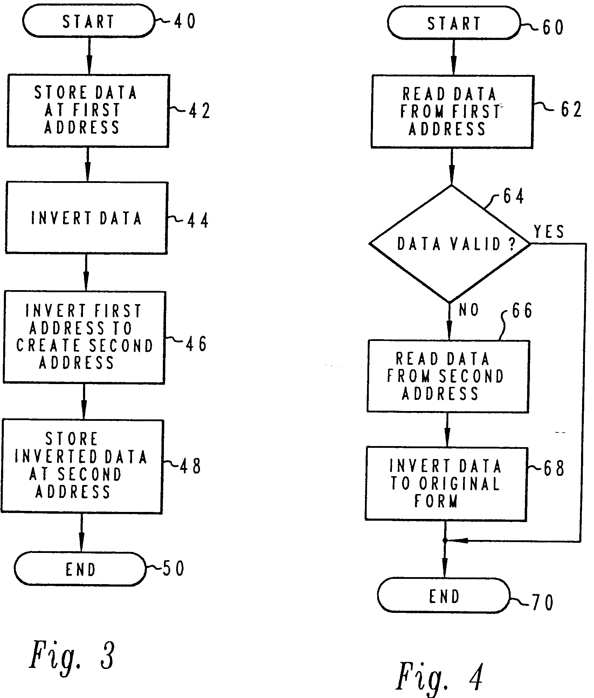

Referring now to Figure 3 there is depicted a high level logic flow chart which illustrates the storage of data within a data processing system in accordance with the method and system of the present invention described above. As illustrated, the process begins at block 40 thereafter passes to block 42 which depicts the storing of data at first address within the memory device. Next, the process passes to block 44 which illustrates the inverting of that data and thereafter, block 46 depicts the creation of a second address by logically inverting the first address.

Finally, block 48 illustrates the storing of the inverted data at the second address and after storing all data the process then terminates, as depicted at block 50. Thus, in this manner the method and system of the present invention may be utilized to automatically store vital data at a first address within a memory device and thereafter invert the data and store that inverted data at a second address which is the logical inverse of the first address.

Finally, referring to Figure 4 there is depicted a logic flow chart which illustrates the retrieval of data within a data processing system in accordance with the method and system of the present invention. As above, the process begins at block 60 and thereafter passes to block 62 which illustrates the reading of data from a first address within the memory device. Next, the process passes to block 64 which illustrates a determination of whether or not the data thus read is valid. In a preferred embodiment, three parity bits are stored with each byte (8 bits) of separately addressable data. Two of these bits represent parity bits for the data (each covering 4 bits, or half, of the data), and the third represents parity of the address. If either data parity bit is incorrect, the stored data has possibly been corrupted; if the address parity bit is incorrect, data is being retrieved from the wrong location. In either event, the retrieved data is invalid. Those skilled in the art will appreciate that various alternate parity checks or other techniques may be utilized to determine whether or not the data retrieved is valid. For example, data retrieved by service personnel may be compared to a data base stored within a host computer to determine the validity thereof. In either event, if the data thus retrieved is valid the process passes block 70 and terminates.

However, in the event the data retrieved at block 62 is determined not to be valid, as depicted within block 64, the process passes to block 66. Block 66 depicts the reading of the data from a second address and the process then passes to block 68. Block 68 illustrates the logical inversion of the data stored at the second address to create a true form of the vital data and the process then passes to block 70 and terminates.

Upon reference to foregoing of those skilled in the art will appreciate that the applicant has created a method and system whereby vital data may be recovered from a data processing system despite the presence of errors within the data or address interface to a memory device, without requiring sophisticated hardware or software manipulation techniques.

## Claims

1. A data processing system for ensuring the recoverability of vital data stored within memory means associated with said data processing system, said data processing system comprising:
memory means;
means for storing vital data comprising a plurality of binary bits at a first address within said memory means; and
means for storing said vital data at a second address within said memory means in a logically inverted form wherein data errors which occur during retrieval of said vital data from said first address may be corrected by a retrieval of said vital data from said second address.

2. The data processing system for ensuring the recoverability of vital data stored within memory means associated with said data processing system according to Claim 1, further including means for determining validity of said vital data after retrieval thereof.

3. The data processing system for ensuring the recoverability of vital data stored within memory means associated with said data processing system according to Claim 1 or 2, wherein said memory means comprises a random access memory.

4. The data processing system for ensuring the recoverability of vital data stored within memory means associated with said data processing system according to any one of Claims 1-3, wherein said means for storing said vital data at a second address within said memory means in a logically inverted form comprises means for storing said vital data at a second address comprising a logical inverse of said first address.

5. A data processing system for ensuring the recoverability of vital data stored within memory means associated with said data processing system, said data processing system comprising:
memory means:
means for storing vital data comprising a plurality of binary bits at a first address within said memory means; and
means for storing said vital data at a second address within said memory means, said second address comprising a logical inverse of said first address wherein address errors which occur during retrieval of said vital data from said first address may be corrected by a retrieval of said vital data from said second address.

6. The data processing system for ensuring the recoverability of vital data stored within memory means associated with said data processing system according to Claim 5, further including means for determining validity of said vital data after retrieval thereof.

7. The data processing system for ensuring the recoverability of vital data stored within memory means associated with said data processing system according to Claim 5 or 6, wherein said memory means comprises a random access memory.

8. A method in a data processing system for ensuring recoverability of vital data stored within memory means associated with said data processing system, said method comprising the steps of:
storing vital data comprising a plurality of binary bits at a first address within said memory means; and
storing said vital data at a second address within said memory means in a logically inverted form wherein data errors which occur during retrieval of said vital data from said first address may be corrected by a retrieval of said vital data from said second address.

9. The method in a data processing system for ensuring the recoverability of vital data stored within memory means associated with said data processing system according to Claim 8 further including the step of determining validity of said vital data after retrieval from said first address.

10. The method in a data processing system for ensuring the recoverability of vital data stored within memory means associated with said data processing system according to Claim 9, further including the step of retrieving said vital data from said second address in response to a determination of nonvalidity of said vital data retrieved from said first address.

11. A method in a data processing system for ensuring the recoverability of vital data stored within memory means associated with said data processing system, said method comprising the steps of:
storing vital data comprising a plurality of binary bits at a first address within said memory means; and
storing said vital data at a second address within said memory means, said second address comprising a logical inverse of said first address wherein address errors which occur during retrieval of said vital from said first address may be correct by retrieval of said vital data from said second address.

12. The method in a data processing system for ensuring the recoverability of vital data stored within memory means associated with said data processing system according to Claim 11, further including the step of determining validity of said vital data after retrieval from said first address.

13. The method in a data processing system for ensuring the recoverability of vital data stored within memory means associated with said data processing system according to Claim 12, further including the step of retrieving said vital data from said second address in response to a determination of nonvalidity of said vital data retrieved from said first address.
